(19) Europäisches Patentamt
European Patent Office
Office européen des brevets

(11) Veröffentlichungsnummer: **0 037 924**
**B1**

(12) # EUROPÄISCHE PATENTSCHRIFT

(45) Veröffentlichungstag der Patentschrift: **12.06.85**

(21) Anmeldenummer: **81102139.3**

(22) Anmeldetag: **21.03.81**

(51) Int. Cl.[4]: **C 08 L 81/00,** C 08 L 85/00, C 08 K 5/00, H 01 B 1/12, H 01 L 29/28, H 01 L 31/02, H 01 L 43/10

(54) **Verfahren zur Herstellung von elektrisch leitfähigen Polykondensaten und deren Verwendung in der Elektrotechnik und zur antistatischen Ausrüstung von Kunststoffen.**

(30) Priorität: **11.04.80 DE 3013924**

(43) Veröffentlichungstag der Anmeldung: **21.10.81 Patentblatt 81/42**

(45) Bekanntmachung des Hinweises auf die Patenterteilung: **12.06.85 Patentblatt 85/24**

(84) Benannte Vertragsstaaten: **AT BE CH DE FR GB LI NL**

(56) Entgegenhaltungen:
**EP - A - 0 023 596**
**US - A - 4 025 463**

**JOURNAL OF CHEMICAL PHYSICS, Band 71, Nr. 1, 1. August 1979 Lancaster D.M. IVORY et al. "Highly Conducting Charge-Transfer Complexes of Poly(p-Phenylene)" Seiten 1506, 1507**
**SYNTHETIC METALS, Band 1, 1979 Lausanne L.W. SHACKLETTE et al. "Electrical and Optical Properties of Highly Conducting Charge-Transfer Complexes of Poly(p-Phenylene)" Seiten 307 bis 320**
**DIE NATURWISSENSCHAFTEN, Band 56, Nr. 6, 1969 H. NAARMANN "Polymere organische Halbleiter" Seiten 308 bis 313**

**Die Akte enthält technische Angaben, die nach dem Eingang der Anmeldung eingereicht wurden und die nicht in dieser Patentschrift enthalten sind.**

(73) Patentinhaber: **BASF Aktiengesellschaft, Carl-Bosch-Strasse 38, D-6700 Ludwigshafen (DE)**

(72) Erfinder: **Naarmann, Herbert, Dr., Haardtblick 15, D-6719 Wattenheim (DE)**
Erfinder: **Penzien, Klaus, Dr., Bensheimer Ring 18, D-6710 Frankenthal (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Die Erfindung betrifft ein Verfahren zur Herstellung von elektrisch leitfähigen Polykondensaten mit elektrischen Leitfähigkeitswerten grösser als $10^{-2}$ S/cm und deren Verwendung in der Elektroindustrie sowie zur antistatischen Ausrüstung von Kunststoffen.

Es ist bereits bekannt, Polykondensate durch oxidative Kupplung entsprechend der Literatur: «Macromolecular Syntheses Collective», Vol. 1, (1979) Seiten 109 bis 110, Verlag John Wiley & Sons und «Naturwissenschaften» 56 (1969) Seiten 308 bis 313 herzustellen. Ausserdem ist die Herstellung von Polykondensaten durch stufenweise Polykondensation nach R. Gehm und W. Kern aus «Makromolekulare Chemie» 7 (1951) Seiten 46–61 bekannt, wobei besonders einheitliche, para-verkettete methylsubstituierte Derivate erhalten werden, die nicht zusätzlich durch ortho- oder meta-verknüpfte Polymere verunreinigt sind. Ebenfalls bekannt sind Polykondensate, die z.B. durch Tetrachlorbenzochinon mit $Na_2S$ erhalten werden und in dem DE-PS 119 719 beschrieben sind.

Der Erfindung lag die Aufgabe zugrunde, die an sich bekannten Polykondensate durch Zusätze in elektrisch leitfähige Polymere mit elektrischen Leitfähigkeiten grösser als $10^{-2}$ S/cm umzuwandeln.

Diese Aufgabe wurde erfindungsgemäss dadurch gelöst, dass man den Polykondensaten der allgemeinen Formeln

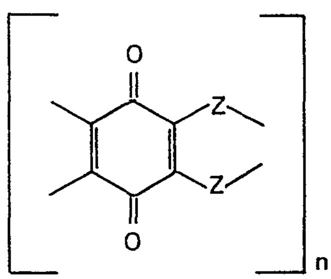

oder

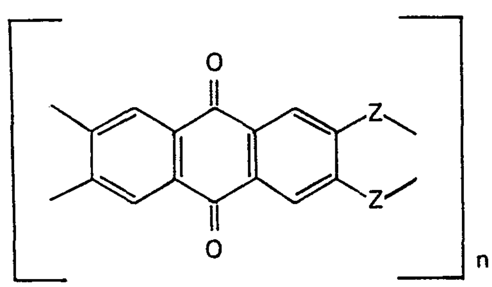

worin n gleich 1 bis 50 und Z gleich Schwefel oder Selen ist, unter Ausschluss von Wasserfeuchtigkeit 0,5 bis 15 Gew.%, bezogen auf das eingesetzte Polykondensat, an Lewis-Säuren, sowie deren $NO^+$- oder $NO_2^+$-Salze ferner Nitroaromaten, Trinitrosulfonsäure und/oder Fluorderivate oder auch Säuren zugesetzt werden.

Nach bevorzugter Verfahrensweise werden die Lewis-Säuren in Nitromethan und/oder Methylenchlorid, jeweils im Molverhältnis 1:1 bis 1:50, vorzugsweise 1:2 bis 1:3, zugesetzt.

Die Polykondensate sind bekannte höhermolekulare Produkte, deren Ketten vollständig aus aneinander gekoppelten Aromatsystemen gemäss der allgemeinen Formel bestehen, und die durch Kondensation von Halogenchinonen mit löslichen Sulfiden und/oder Seleniden erhalten werden. Das Einführen der Se-Brücken erfolgt analog der Synthese mit löslichen Sulfiden entsprechend der DE-PS 1 179 719. Bevorzugt sind die Polykondensate mit Benzochinon-Einheiten und Schwefel oder Selen-Brücken. Die Polykondensate weisen ein Molgewicht von 200 bis 5000 auf, d.h. n=1 bis 50. Die Herstellung der Polykondensate kann nach der eingangs zitierten Literatur erfolgen. In der obigen Formel kann das chinoide System, anstelle von Benzochinon ein anderes z.B. Anthrachinon sein, S ist Schwefel oder Selen.

Die elektrischen Leitfähigkeitswerte werden in S/cm bei 30°C gemessen, die Messung selbst erfolgt nach der Methode von F. Beck, «Berichte Bunsengesellschaft, Physikalische Chemie» 68 (1964) Seiten 558 bis 567. Die elektrischen Leitfähigkeitswerte der erfindungsgemässen leitfähigen Polykondensate sind grösser als $10^{-2}$S/cm. Die Herstellung der Polykondensate kann auch nach P.R. Schildneck et. al., J. Amer. Chem. Soc. 53 (1931), Seite 2373 erfolgen.

Nach dem erfindungsgemässen Verfahren wird den Polykondensaten unter Ausschluss von Wasserfeuchtigkeit 0,5 bis 15 Gew.%, bezogen auf die eingesetzten Polykondensate, an Lewis-Säuren, wie Antimon- oder Arsenpentafluorid sowie deren $NO^+$- oder $NO_2^+$-Salze, ferner Nitroaromate wie Trinitrophenol, Trinitrosulfonsäure, und/oder Fluorderivate wie $CF_3$-COOH oder auch Säuren wie Schwefelsäure, Salpetersäure oder Überchlorsäure zugesetzt.

Das Einarbeiten der Zusätze erfolgt unter Ausschluss von Feuchtigkeit (Wasser), es wird vorzugsweise unter Argonatmosphäre gearbeitet. Vorzugsweise werden Hilfsflüssigkeiten wie Tetrahydrofuran, Notromethan oder $CCl_4$ oder $CHCl_3$, jeweils im Molverhältnis 1:1 bis 1:50 eingesetzt, die nach dem Einarbeiten bie Temperaturen unter 30°C im Vakuum abgezogen werden. Das obige Molverhältnis ist bevorzugt 1:2 bis 1:3.

Durch die genannten Zusätze können elektrische Leitfähigkeitsanstiege von einigen Grössenordnungen erreicht werden. Die Ausgangsleitfähigkeiten der nach der dem DE-PS 1 179 719 oder analog hergestellten Polykondensate betrugen ca. $10^{-6}$ bis $10^{-8}$ S/cm. Die nach der stufenweisen Kondensation hergestellten Polykondensate haben Ausgangsleitfähigkeiten von weniger als $10^{-6}$ S/cm, liefern aber nach der Zugabe der erfindungsgemässen Zusätze Leitfähigkeiten von mindestens $10^{-2}$ S/cm.

Die erfindungsgemäss hergestellten elektrisch leitfähigen Polykondensate mit elektrischen Leitfähigkeiten von mindestens $10^{-2}$ S/cm sind zur

antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der starken Lewis-Säure zum Polykondensat entstehen sog. p-Leiter.

Die in den folgenden Beispielen genannten Teile sind Gewichtsteile. Die Angabe der Gleiderzahl n (Kettenlänge der Polykondensate) erfolgt durch Endgruppenanalyse über IR-Bestimmung des Verhältnisses der monofunktionellen Endgruppe zur difunktionellen Mittelgruppe.

Beispiel 1–7

10 Teile eines Polykondensates werden unter Argonatmosphäre und Ausschluss von Feuchtigkeit mit dem jeweiligen Zusatzmittel versetzt, die Messung der elektr. Leitfähigkeit erfolgt nach F. Beck, «Ber. Bunsengesellschaft, Phys. Chem.» 68, 558 bis 567 (1964).

| Nr. | Polykondensat Typ und Menge | n | Dopingmittel Art und Menge (Mol %) | Leitfähigkeit S/cm 30°C vor dem Dopen, | nach dem Dopen |
|---|---|---|---|---|---|
| 1 | 10 Teile 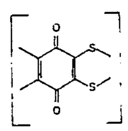 | 5 | 0,2 $AsF_5$ | $\sim 10^{-8}$ | $3{,}5 \cdot 10^{-2}$ |
| 2 | 10 Teile 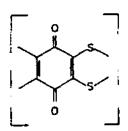 | ca. 10 | 0,25 $AsF_5$ | $\sim 10^{-8}$ | $4{,}9 \cdot 10^{-1}$ |
| 3 | 10 Teile 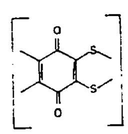 | ca. 15 | 0,2 $AsF_5$ | $\sim 10^{-8}$ | $2{,}0 \cdot 10^{+1}$ |
| 4 | 10 Teile 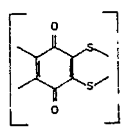 | ca. 25 | 0,3 $AsF_5$ | $\sim 10^{-6}$ | $4{,}8 \cdot 10^{+2}$ |
| 5 | 10 Teile 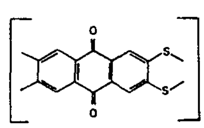 | ca. 5 | 0,4 $NO_2^+SbF_6$ | $\sim 10^{-8}$ | $3{,}6 \cdot 10^{-1}$ |
| 6 | 10 Teile 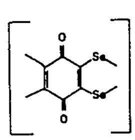 | 10 | 0,3 $SbF_5$ | $\sim 10^{-8}$ | $6{,}4 \cdot 10^{+2}$ |
| 7 | 10 Teile 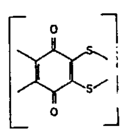 | | 0,2 Trinitrobenzolsulfosäure | $\sim 10^{-8}$ | $2{,}5 \cdot 10^{-2}$ |

## Patentansprüche

1. Verfahren zur Herstellung von elektrisch leitfähigen Polykondensaten mit elektrischen Leitfähigkeitswerten grösser als $10^{-2}$ S/cm dadurch gekennzeichnet, dass den Polykondensaten der allgemeinen Formeln

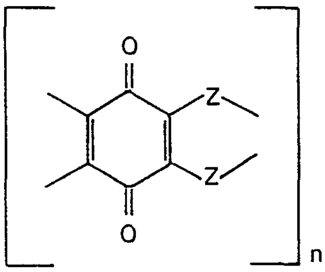

oder

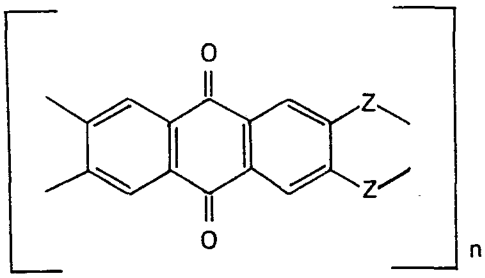

worin n gleich 1 bis 50 und Z gleich Schwefel oder Selen ist, unter Ausschluss von Wasserfeuchtigkeit 0,5 bis 15 Gew.%, bezogen auf den eingesetzten Polykondensat, an Lewis-Säuren sowie deren $NO^+$- oder $NO_2^+$-Salze, ferner Nitroaromate, Trinitrosulfonsäure und/oder Fluorderivate oder auch Säuren zugesetzt werden.

2. Verwendung der nach Anspruch 1 hergestellten leitfähigen Polykondensaten in der Elektrotechnik zur Herstellung von Sonnenzellen, zur Umwandlung und Fixierung von Strahlung und zur Herstellung elektrischer und magnetischer Schalter.

3. Verwendung der nach Anspruch 1 hergestellten leitfähigen Polykondensaten zur antistatischen Ausrüstung von Kunststoffen.

**Claims**

1. A process for the preparation of electrically conductive polycondensates having electrical conductivities greater than $10^{-2}$ S/cm, wherein there is added to the polycondensates of the general formula

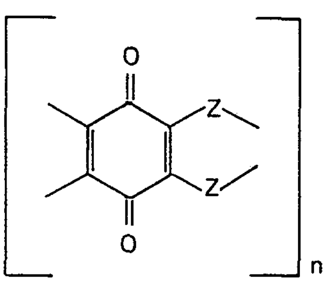

or

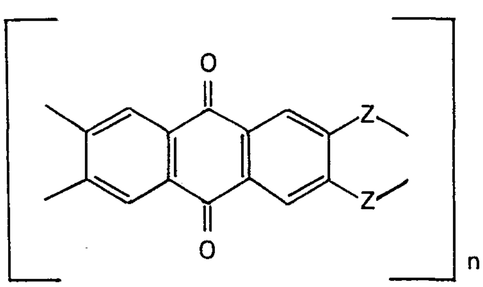

where n is from 1 to 50 and Z is sulphur or selenium, while excluding moisture, from 0.5 to 15% weight, based on the polycondensate used, of a Lewis acid or an $NO^+$ or $NO_2^+$ salt thereof, or a nitroaromatic, trinitrosulphonic acid and/or a fluorine derivative, or another acid.

2. The use of the conductive polycondensates prepared as claimed in claim 1, in electrical engineering, for the production of solar cells, for the conversion and fixation of radiation, and for the production of electrical and magnetic switches.

3. The use of the conductive polycondensates prepared as claimed in claim 1 for the antistatic finishing of plastics.

**Revendications**

1. Procédé de préparation de polycondensats conducteurs de l'électricité avec des conductibilités électriques supérieures à $10^{-2}$ S/cm, caractérisé en ce que l'on incorpore à des polycondensats de l'une des formules générales

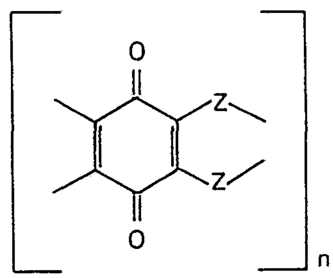

et

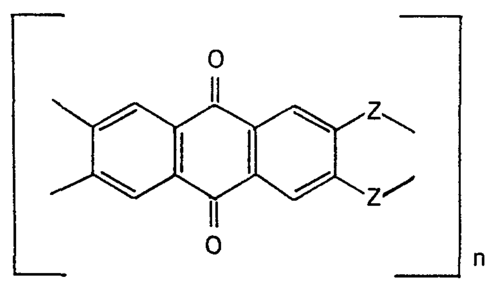

dans lesquelles Z désigne du soufre ou du sélénium et n vaut de 1 à 50, à l'abri de l'humidité, entre 0,5 et 15% du poids du polycondensat d'acides de Lewis ou de sels de $NO^+$ ou de $NO_2^+$ de ces acides ou encore de composés aromatiques nitrés, d'acide trinitro-sulfonique et (ou) de dérivés fluorés ou d'autres acides.

2. Utilisation des polycondensats conducteurs, préparés par le procédé selon la revendication 1, dans le domaine électro-technique pour la fabrication de cellules solaires, pour la transformation et la fixation de rayonnements et pour la fabrication de commutateurs électriques ou magnétiques.

3. Utilisation des polycondensats conducteurs, préparés par le procédé selon la revendication 1, pour l'apprêtage antistatique de matières plastiques.